# EUROPÄISCHE PATENTSCHRIFT

(11) **EP 3 254 127 B1**
(45) Veröffentlichungstag und Bekanntmachung des Hinweises auf die Patenterteilung: **24.11.2021**
(21) Anmeldenummer: 16702942.0
(22) Anmeldetag: 04.02.2016
(51) Int. Cl.: G01R 31/62

(54) **TRANSFORMATORPRÜFVORRICHTUNG UND VERFAHREN ZUM PRÜFEN EINES DREIWICKLUNGSTRANSFORMATORS**
TRANSFORMER TEST DEVICE AND METHOD FOR TESTING A THREE-WINDING TRANSFORMER
TESTEUR DE TRANSFORMATEUR ET PROCÉDÉ DE TEST D'UN TRANSFORMATEUR À TROIS ENROULEMENTS

(30) Priorität: 06.02.2015 AT 500932015
(43) Veröffentlichungstag der Anmeldung: 13.12.2017
(73) Patentinhaber: Omicron electronics GmbH, 6833 Klaus (AT)
(72) Erfinder: KAUFMANN, Reinhard, 6721 Thüringerberg (AT); KLAPPER, Ulrich, 6830 Rankweil (AT); PÜTTER, Markus, 6832 Sulz (AT)
(74) Vertreter: Banzer, Hans-Jörg
(86) Internationale Anmeldenummer: PCT/EP2016/052402
(87) Internationale Veröffentlichungsnummer: WO 2016/124698

(56) Entgegenhaltungen:
- EP-A1- 2 664 933
- WO-A1-2009/018850
- US-A1- 2003 139 891
- US-A1- 2011 031 980
- US-A1- 2014 125 351
- AVO INTERNATIONAL: "Transformer Turns Ratio Test Set", INTERNET CITATION, 1999, XP002330453, Gefunden im Internet: URL:http://www.megger.com/common/documents /FB_FBY550503_DS_En_V01.pdf [gefunden am 2005-06-03]

## Beschreibung

### GEBIET DER ERFINDUNG

Ausführungsbeispiele der Erfindung betreffen eine Vorrichtung und ein Verfahren zum Prüfen eines Transformators. Ausführungsbeispiele der Erfindung betreffen insbesondere derartige Vorrichtungen und Verfahren, mit denen wenigstens eine Kenngröße eines Dreiwicklungstransformators ermittelt werden kann.

### HINTERGRUND

Transformatoren werden als Bestandteile von Energieversorgungsnetzen verwendet. Transformatoren können zur Spannungswandlung von einem ersten Wert an einer Oberspannungsseite zu einem zweiten Wert, der kleiner als der erste Wert ist, an einer Unterspannungsseite eingesetzt werden.

Die Bestimmung von Eigenschaften Transformators durch eine Transformatorprüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Messungen beinhalten die Bestimmung eines statischen Widerstands, eines Übersetzungsverhältnisses, einer Streuinduktivität oder Streureaktanz.

In der Technik werden Dreiwicklungstransformatoren weithin eingesetzt, beispielsweise um unterschiedliche Schaltgruppen zu bilden. Dreiwicklungstransformatoren können beispielsweise als Einphasen-Dreiwicklungstransformatoren oder Dreiphasen- Dreiwicklungstransformatoren ausgestaltet sein. Dreiwicklungstransformatoren unterschiedlicher Vektorgruppen, die die Verschaltung primärer, sekundärer und tertiärer Wicklungen beschreiben, werden verwendet.

Es besteht ein Bedarf an Vorrichtungen und Verfahren, die die Ermittlung wenigstens einer Kenngröße eines Dreiwicklungstransformators ermöglichen. Es besteht ein Bedarf an Vorrichtungen und Verfahren, die eine Automatisierung der Ermittlung derartiger Kenngrößen erlauben, ohne dass signifikante Umverdrahtungen vorgenommen werden müssen.

### ZUSAMMENFASSUNG DER ERFINDUNG

Die Erfindung bezieht sich auf eine Transformatorprüfvorrichtung gemäß Anspruch 1, ein Erweiterungsgerät gemäß Anspruch 5 und ein Verfahren gemäß Anspruch 14.

Besondere Ausführungsformen sind in den unabhängigen Ansprüchen beansprucht.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt ein System mit einer Transformatorprüfvorrichtung nach einem Ausführungsbeispiel.
Figur 2 zeigt ein System mit einer Transformatorprüfvorrichtung nach einem Ausführungsbeispiel.
Figur 3 zeigt ein System mit einer Transformatorprüfvorrichtung nach einem Ausführungsbeispiel.
Figur 4 zeigt ein Blockdiagramm eines Erweiterungsgeräts nach einem Ausführungsbeispiel.
Figur 5 zeigt ein System mit einer Transformatorprüfvorrichtung nach einem Ausführungsbeispiel.
Figur 6 zeigt ein System mit einer Transformatorprüfvorrichtung nach einem Ausführungsbeispiel.
Figur 7 zeigt ein System mit einer Transformatorprüfvorrichtung nach einem Ausführungsbeispiel.
Figur 8 zeigt ein System mit einer Transformatorprüfvorrichtung nach einem Ausführungsbeispiel.
Figur 9 ist ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren zum Prüfen eines Dreiwicklungstransformators detailliert beschrieben. Der Dreiwicklungstransformator kann ein Transformator für Hoch- oder Mittelspannungsnetze sein. Der Dreiwicklungstransformator kann ein in einem Kraftwerk oder Umspannwerk installierter Transformator sein. Die Transformatorprüfvorrichtung kann ein mobiles Gerät sein oder kann aus mehreren mobilen Geräten aufgebaut sein, um die Durchführung der Messungen an dem installierten Transformator zu erlauben.

Die Transformatorprüfvorrichtung kann eingerichtet sein, um gleichzeitig mit wenigstens einer primären Wicklung, einer sekundären Wicklung und einer tertiären Wicklung des Dreiwicklungstransformators verbunden zu sein. Die primäre Wicklung, die sekundäre Wicklung und die tertiäre Wicklung können denselben Transformatorkern aufweisen.

Zur Verbindung mit dem Dreiwicklungstransformator kann die Transformatorprüfvorrichtung zusätzlich zu wenigstens einem ersten Anschluss zur Verbindung mit einer primären Wicklung und wenigstens einem zweiten Anschluss zur Verbindung mit einer sekundären Wicklung einen oder mehrere Anschlüsse aufweisen, um die gleichzeitige Verbindung auch mit der tertiären Wicklung des Dreiwicklungstransformators zu erlauben.

Wie noch ausführlicher beschrieben wird, kann die Transformatorprüfvorrichtung so ausgestaltet sein, dass ein Erweiterungsgerät mit einem Transformatorprüfgerät reversibel lösbar verbunden wird, um die gleichzeitige Verbindung der Transformatorprüfvorrichtung mit wenigstens einer primären Wicklung, einer sekundären Wicklung und einer tertiären Wicklung des Dreiwicklungstransformators zu ermöglichen.

Bei Vorrichtungen und Verfahren können unterschiedliche Kenngrößen des Transformators automatisch bestimmt werden. Beispielsweise können mehrere Übersetzungsverhältnisse des Transformators automatisch bestimmt werden, ohne hierfür eine Umverdrahtung vornehmen zu müssen. Es können auch andere Kenngrößen wie statische oder dynamische Widerstände oder eine Streureaktanz und/oder eine Streuinduktivität des Transformators ermittelt werden. Dazu kann von der Transformatorprüfvorrichtung eine Prüfantwort ausgewertet werden, die als Reaktion auf ein Prüfsignal erfasst wird.

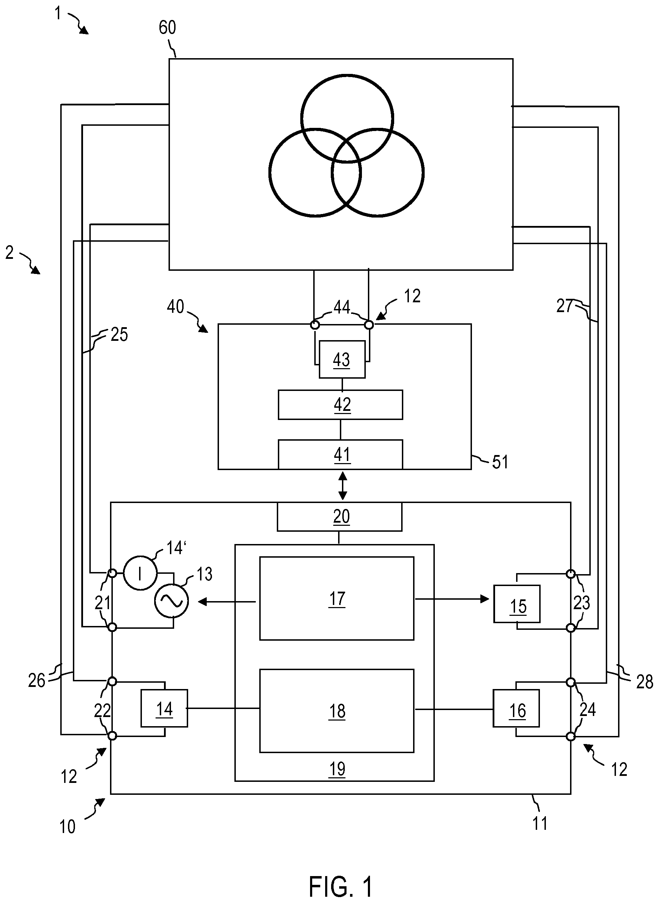

Figur 1 zeigt ein System 1 mit einer Transformatorprüfvorrichtung 2 zum Ermitteln einer Kenngröße eines Dreiwicklungstransformators 60 nach einem Ausführungsbeispiel.

Das System 1 umfasst den Dreiwicklungstransformator 60 und die Transformatorprüfvorrichtung 2. Die Transformatorprüfvorrichtung 2 kann als ein einziges Gerät mit einem Gehäuse ausgebildet sein. Die Transformatorprüfvorrichtung 2 kann aus einer Anordnung von mehreren Geräten 10, 40 oder Einrichtungen bestehen, wie in Figur 1 dargestellt ist. Die mehreren Geräte oder Einrichtungen können in diesem Fall von einer zentralen Steuerung gesteuert werden. Die Transformatorprüfvorrichtung 2 kann ein Transformatorprüfgerät 10 und ein damit verbundenes Erweiterungsgerät 40 umfassen. Das Transformatorprüfgerät 10 kann als mobiles Gerät und insbesondere als portables Gerät ausgebildet sein. Das Erweiterungsgerät 40 kann als mobiles Gerät und insbesondere als portables Gerät ausgebildet sein.

Wie noch ausführlicher beschrieben wird, weist die Transformatorprüfvorrichtung 2 zusätzliche Anschlüsse auf, um eine gleichzeitige Verbindung mit den Wicklungen des Dreiwicklungstransformators 60 zu ermöglichen. Beispielsweise kann das Transformatorprüfgerät 10 Anschlüsse zur Verbindung mit einer primären Wicklung und einer sekundären Wicklung des Dreiwicklungstransformators 60 umfassen, und das Erweiterungsgerät 40 kann mehrere Anschlüsse 40 zur Verbindung mit einer oder mehreren tertiären Wicklungen des Dreiwicklungstransformators 60 umfassen. Andere Ausgestaltungen sind möglich. Beispielsweise kann das Erweiterungsgerät 40 mehrere Anschlüsse 40 zur Verbindung mit einer oder mehreren primären Wicklungen und/oder zur Verbindung mit einer oder mehreren primären Wicklungen des Dreiwicklungstransformators 60 umfassen.

Der Dreiwicklungstransformator 60 kann ein Leistungstransformator einer elektrischen Energieversorgungseinrichtung sein. Der Dreiwicklungstransformator 60 kann fest in einem Kraftwerk oder Umspannwerk verbaut sein, während mit der Transformatorprüfvorrichtung 2 eine Transformatorprüfung ausgeführt wird. Der Dreiwicklungstransformator 60 kann ein Spannungswandler oder Stromwandler sein. Der Dreiwicklungstransformator 60 kann ein Spannungswandler oder Stromwandler sein, der nach induktivem Wirkprinzip arbeitet.

Der Dreiwicklungstransformator 60 umfasst wenigstens eine primäre Wicklung, wenigstens eine sekundäre Wicklung und wenigstens eine tertiäre Wicklung. Mehrere Wicklungen können in an sich bekannter Weise in Schaltgruppen kombiniert sein.

Die Transformatorprüfvorrichtung 2 umfasst eine Mehrzahl von Anschlüssen 12 zur Verbindung mit dem Dreiwicklungstransformator 60, eine Quelle 13 für ein Prüfsignal, das an den Dreiwicklungstransformator 60 als Prüfling bei der Transformatorprüfung angelegt oder eingeprägt wird, und eine Auswerteeinrichtung 18. Eine oder mehrere Messeinrichtungen 14, 16 zum Erfassen einer Prüfantwort des Dreiwicklungstransformators 60 können in die Transformatorprüfvorrichtung 2 integriert sein. Ein oder mehrere steuerbare Schaltmittel 15 können in die Transformatorprüfvorrichtung 2 integriert sein. Die Quelle 13, wenigstens eine Messeinrichtung 14, 16 und eine Auswerteeinrichtung 18 können in einem Gehäuse 11 des Transformatorprüfgeräts 10 verbaut sein.

Die Transformatorprüfvorrichtung 2 kann eine Messeinrichtung 14' zum Erfassen einer Stromstärke der Quelle 13 umfassen. Die Messeinrichtung 14' kann in die Quelle 13 integriert sein.

Die Quelle 13 kann eine Stromquelle sein, die steuerbar ist, um einen Wechselstrom als Prüfsignal zu erzeugen. Die Quelle 13 kann steuerbar sein, um Wechselströme mit mehreren unterschiedlichen Frequenzen als Prüfsignal zu erzeugen. Die Quelle 13 kann auch eine Spannungsquelle sein. Die Quelle 13 kann in unterschiedlichen Betriebsmodi betreibbar sein, beispielsweise als Stromquelle oder als Spannungsquelle und/oder als Quelle eines zeitlich konstanten Signals oder eines Wechselsignals. Das von der Quelle 13 erzeugte Prüfsignal kann über die Anschlüsse 13 und die Leitungen 35 an der Unterspannungsseite 43 eingeprägt werden.

Die Transformatorprüfvorrichtung 2 umfasst ein Erweiterungsgerät 40. Das Erweiterungsgerät 40 kann separat von dem Transformatorprüfgerät 10 ausgebildet sein. Das Erweiterungsgerät 40 kann für eine elektronische und optional auch mechanische Kopplung mit dem Transformatorprüfgerät 10 ausgestaltet sein. Durch Hinzufügen des Erweiterungsgeräts 40 können zusätzliche Anschlüsse 44 vorgesehen werden, mit denen erreicht werden kann dass die aus dem Transformatorprüfgerät 10 und dem Erweiterungsgerät 40 gebildete Transformatorprüfvorrichtung 2 gleichzeitig mit wenigstens einer primären Wicklung, wenigstens einer sekundären Wicklung und wenigstens einer tertiären Wicklung des Dreiwicklungstransformators 60 verbunden werden kann.

Das Erweiterungsgerät 40 kann wenigstens eine Einrichtung 43 umfassen, die mit den Anschlüssen 44 gekoppelt ist. Die Einrichtung 43 kann ein steuerbares Schaltmittel umfassen, mit dem eine Wicklung des Dreiwicklungstransformators 60 durch das Erweiterungsgerät 40 so kurzgeschlossen wird, dass ein Kurzschlussstrom durch das Erweiterungsgerät 40 fließt. Die Einrichtung 43 kann eine Strom- oder Spannungsmesseinrichtung umfassen.

Das Erweiterungsgerät 40 weist eine Schnittstelle 41 zur Kommunikation mit einer Schnittstelle 20 des Transformatorprüfgeräts 10 auf. Die Schnittstelle 41 des Erweiterungsgeräts 40 kann eine digitale Schnittstelle sein. Die Schnittstelle 41 des Erweiterungsgeräts 40 kann eine Ethernet-Schnittstelle sein. Die Schnittstelle 41 des Erweiterungsgeräts 40 kann eine Echtzeit-Ethernet-Schnittstelle sein. Die Schnittstelle 41 des Erweiterungsgeräts 40 kann eine EtherCAT ("Ethernet for Control Automation Technology")-Schnittstelle sein.

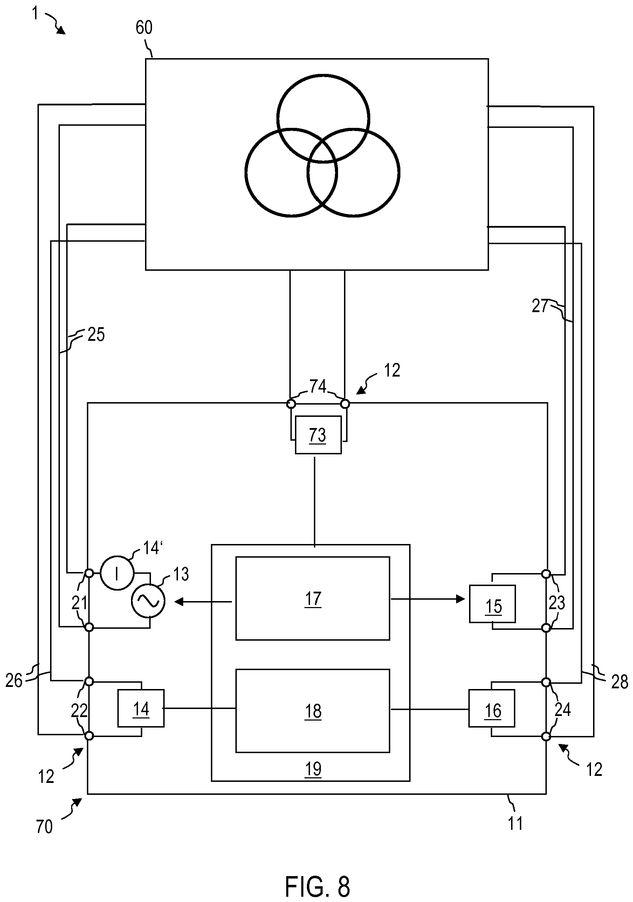

Das Transformatorprüfgerät 10 weist eine Schnittstelle 20 zur Kommunikation mit der Schnittstelle 41 des Erweiterungsgeräts 40 auf. Die Schnittstelle 20 des Transformatorprüfgeräts 10 kann eine digitale Schnittstelle sein. Die Schnittstelle 20 des Transformatorprüfgeräts 10 kann eine Ethernet-Schnittstelle sein. Die Schnittstelle 20 des Transformatorprüfgeräts 10 kann eine Echtzeit-Ethernet-Schnittstelle sein. Die Schnittstelle 20 des Transformatorprüfgeräts 10 kann eine EtherCAT-Schnittstelle sein. Bei weiteren Ausführungsbeispielen kann die Schnittstelle 20 weggelassen werden, wie beispielsweise unter Bezugnahme auf Figur 8 noch ausführlicher beschrieben wird.

Die Transformatorprüfvorrichtung 2 weist mehrere Anschlüsse 12 zum Verbinden der Transformatorprüfvorrichtung 2 mit dem Dreiwicklungstransformator 60 auf. Die mehreren Anschlüsse 12 können so ausgestaltet sein, dass sie eine gleichzeitige Verbindung mit wenigstens drei Wicklungen des Dreiwicklungstransformators 60, die eine primäre Wicklung, eine sekundäre Wicklung und eine tertiäre Wicklung sein können, erlauben.

Die mehreren Anschlüsse 12 können ausgestaltet sein, um mit mehr als drei Wicklungen verbunden zu werden. Beispielsweise kann die Transformatorprüfvorrichtung 2 Anschlüsse 12 aufweisen, die für eine Verbindung mit mehreren Wicklungen jeder von mehreren Phasen eines Dreiphasen-Dreiwicklungstransformators eingerichtet sind.

Die mehreren Anschlüsse 12 können auch auf andere Weise zwischen dem Transformatorprüfgerät 10 und dem Erweiterungsgerät 40 verteilt sein. Beispielsweise kann das Erweiterungsgerät 40 Anschlüsse zur Verbindung mit mehreren Wicklungen einer Phase eines Dreiphasen-Dreiwicklungstransformators aufweisen.

Das Erweiterungsgerät 40 kann eine Steuereinrichtung 42 umfassen. Die Steuereinrichtung 42 kann eine oder mehrere integrierte Halbleiterschaltungen umfassen. Die Steuereinrichtung 42 kann einen Prozessor, einen Mikroprozessor, einen Controller, einen Mikrocontroller, eine anwendungsspezifische Spezialschaltung (ASIC) oder eine Kombination mehrerer derartiger integrierte Halbleiterschaltungen umfassen.

Die Steuereinrichtung 42 kann eingerichtet sein, um ein steuerbares Schaltmittel anzusteuern, um eine Wicklung oder eine Schaltgruppe des Dreiwicklungstransformators 60 kurzzuschließen. Die Steuereinrichtung 42 kann mit der Schnittstelle 41 verbunden sein, um abhängig von an der Schnittstelle 41 empfangenen Daten wenigstens eine Wicklung des Dreiwicklungstransformators 60 kurzzuschließen. Die Steuereinrichtung 42 kann synchronisiert mit einer unter Steuerung des Transformatorprüfgeräts 10 ausgeführten Prüfprozedur das steuerbare Schaltmittel ansteuern. Eine Synchronisation des Erweiterungsgeräts 40 mit dem Transformatorprüfgerät 10 kann über die Schnittstelle 41 erfolgen.

Die Steuereinrichtung 42 kann alternativ oder zusätzlich eingerichtet sein, um Information über ein von dem Erweiterungsgerät 40 erfassten Prüfergebnis über die Schnittstelle 41 an das Transformatorprüfgerät 10 zu melden. Dazu kann die Steuereinrichtung 42 ein Ausgangssignal eines Voltmeters, eines Amperemeters oder einer anderen Messeinrichtung umsetzen und optional weiterverarbeiten, um es über die Schnittstelle 41 an das Transformatorprüfgerät zu übertragen.

Das Transformatorprüfgerät 10 kann die Auswerteeinrichtung 18 umfassen, die abhängig von der Prüfantwort, die an einer oder mehreren Wicklungen des Dreiwicklungstransformators 60 erfasst wird, Kenngrößen des Dreiwicklungstransformators 60 ermittelt.

Das Transformatorprüfgerät 10 kann eine (in Figur nicht dargestellte) Benutzerschnittstelle aufweisen, über die Information über den Dreiwicklungstransformator 60 eingebbar ist. Beispielsweise kann über die Benutzerschnittstelle eine Typenbezeichnung für den Dreiwicklungstransformator 60 eingebbar sein. Das Transformatorprüfgerät 10 kann abhängig von der Typenbezeichnung aus einem nichtflüchtigen Speicher Information über die Vektorgruppe abrufen. Alternativ oder zusätzlich kann über die Benutzerschnittstelle die Vektorgruppe des Dreiwicklungstransformators 60 eingebbar sein. Die Auswerteeinrichtung 18 kann die Information über die Vektorgruppe zur weiteren Verarbeitung der Prüfantwort, insbesondere zur rechnerischen oder kennfeldbasierten Ermittlung wenigstens einer Kenngröße des Dreiwicklungstransformators 60, verwenden.

Das Transformatorprüfgerät 10 kann eingerichtet sein, um automatisch zu erkennen, wenn das Erweiterungsgerät 40 über die Schnittstellen 20, 41 mit dem Transformatorprüfgerät 10 gekoppelt wird. Das Erweiterungsgerät 40 kann über die Schnittstelle 41 Daten an das Transformatorprüfgerät 10 ausgeben, das anzeigt, dass das Erweiterungsgerät 40 an das Transformatorprüfgerät 10 angeschlossen ist. Das Erweiterungsgerät 40 kann über die Schnittstelle 41 weitere Daten an das Transformatorprüfgerät 10 ausgeben, das anzeigt, dass das Erweiterungsgerät 40 über die Anschlüsse 44 mit dem Dreiwicklungstransformator 60 gekoppelt wurde.

Das Transformatorprüfgerät 10 kann eine Prozedur zur Transformatorprüfung abhängig davon verändern, ob das Erweiterungsgerät 40 mit dem Transformatorprüfgerät 10 verbunden ist. Beispielsweise kann das Transformatorprüfgerät 10, wenn das Erweiterungsgerät 40 mit dem Transformatorprüfgerät 10 verbunden ist, während eines Teils der Transformatorprüfung wenigstens eine Wicklung des Dreiwicklungstransformators 60 kurzschließen. Das das Transformatorprüfgerät 10 kann, wenn das Erweiterungsgerät 40 mit dem Transformatorprüfgerät 10 verbunden ist, das Erweiterungsgerät 40 veranlassen, gleichzeitig oder zeitlich versetzt wenigstens eine andere Wicklung des Dreiwicklungstransformators 60 kurzzuschließen.

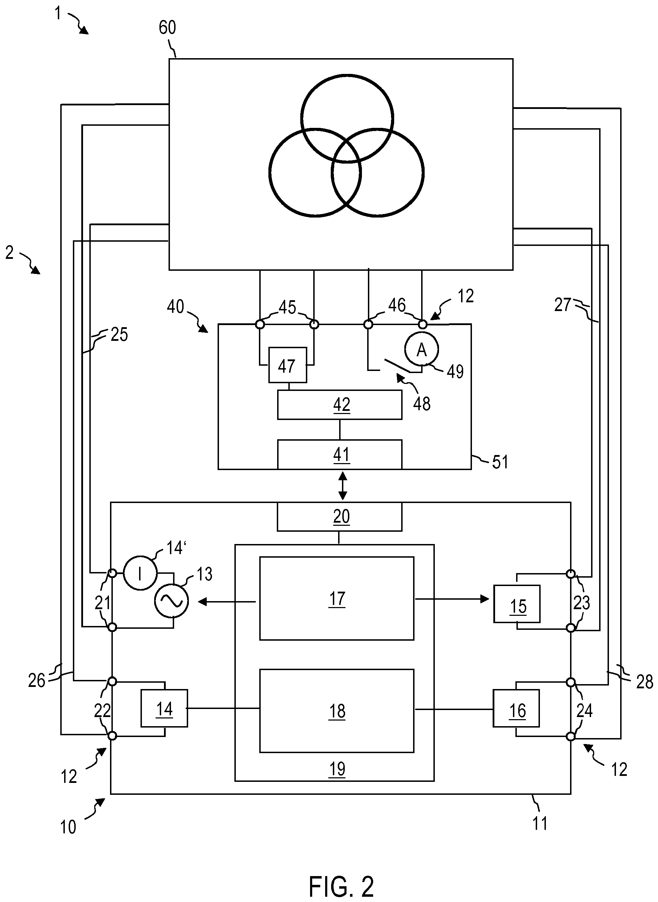

Figur 2 ist eine Darstellung eines Systems 1 mit einer Transformatorprüfvorrichtung 2 und einem Dreiwicklungstransformator 60. Komponenten und Einrichtungen, die mit denselben Bezugszeichen wie in Figur 1 versehen sind, können wie unter Bezugnahme auf Figur 1 beschrieben ausgestaltet sein.

Die Transformatorprüfvorrichtung 2 umfasst ein Transformatorprüfgerät 10 und ein davon verschiedenes Erweiterungsgerät 40. Das Erweiterungsgerät 40 kann ein separates Gehäuse 51 aufweisen und kann über eine digitale Schnittstelle 41 mit dem Transformatorprüfgerät 10 verbunden sein.

Das Erweiterungsgerät 40 weist mehrere Anschlüsse 45, 46 zur Verbindung mit wenigstens einer Wicklung des Dreiwicklungstransformators 60 auf. Das Erweiterungsgerät 40 kann beispielsweise eingerichtet sein, um über die mehreren Anschlüsse 45, 46 mit einer tertiären Wicklung eines Dreiwicklungstransformators 60 gekoppelt zu werden. Das Erweiterungsgerät 40 kann eingerichtet sein, um über die Anschlüsse 45, 46 mit wenigstens einer Wicklung des Dreiwicklungstransformators 60 leitend verbunden zu werden, mit der das Transformatorprüfgerät 10 selbst nicht leitend verbunden ist.

Die mehreren Anschlüsse 45, 46 des Erweiterungsgeräts 40 können eingerichtet sein, um eine Widerstandsmessung an der wenigstens einen Wicklung des Dreiwicklungstransformators 60 zu ermöglichen. Die mehreren Anschlüsse 45, 46 können eingerichtet sein, um eine Widerstandsmessung als eine Vierpunktmessung zu ermöglichen, bei der beispielsweise ein Strom eingeprägt und die Spannung über separate Leitungen erfasst wird.

Das Erweiterungsgerät 40 kann ein steuerbares Schaltmittel 48 umfassen. Das steuerbare Schaltmittel 48 kann unmittelbar von dem Transformatorprüfgerät 10 über die Schnittstelle 41 ansteuerbar sein, um wenigstens eine Wicklung des Dreiwicklungstransformators 60 kurzzuschließen. Alternativ oder zusätzlich kann das steuerbare Schaltmittel 48 von einer Steuereinrichtung 42 des Erweiterungsgeräts 40 angesteuert werden, um wenigstens eine Wicklung des Dreiwicklungstransformators 60 kurzzuschließen. Die Steuereinrichtung 42 kann als Antwort auf an der Schnittstelle 41 von dem Transformatorprüfgerät 10 empfangene Daten das steuerbare Schaltmittel 48 steuern, um wenigstens eine Wicklung des Dreiwicklungstransformators 60 kurzzuschließen. Das steuerbare Schaltmittel 48 kann ein Relais sein oder kann ein Relais umfassen. Das steuerbare Schaltmittel 48 kann ein Bipolartransistor mit isolierter Gate-Elektrode (IGBT) oder ein Feldeffekttransistor (FET) sein oder kann einen IGBT oder einen FET umfassen.

Das Erweiterungsgerät 40 kann eine oder mehrere Messeinrichtungen 47, 49 zum Erfassen einer Prüfantwort des Dreiwicklungstransformators 60. Information über die erfasste Prüfantwort kann von der einen oder den mehreren Messeinrichtungen 47, 49 über die Schnittstelle 41 unmittelbar an das Transformatorprüfgerät 10 übertragen werden. Alternativ oder zusätzlich kann die Steuereinrichtung 42 des Erweiterungsgeräts 10 Ausgangssignale der einen oder mehreren Messeinrichtungen 47, 49 weiter umsetzen, beispielsweise um einen Widerstand, eine Reaktanz, eine Phasenlage und/oder eine Leistung zu berechnen, und um die verarbeiteten Ausgangssignale über die Schnittstelle 41 an das Transformatorprüfgerät 10 zu übertragen.

Das Transformatorprüfgerät 10 kann mit seiner Auswerteeinrichtung 18 eine Prüfantwort, die durch wenigstens eine Messeinrichtung 14, 16 des Transformatorprüfgeräts 10 erfasst wurde, und eine weitere Prüfantwort, die durch wenigstens eine Messeinrichtung 47, 49 des Erweiterungsgeräts 40 erfasst wurde, weiter verarbeiten. Die Prüfantwort, die durch wenigstens eine Messeinrichtung 14, 16 des Transformatorprüfgeräts 10 erfasst wurde, und die weitere Prüfantwort, die durch wenigstens eine Messeinrichtung 47, 49 des Erweiterungsgeräts 40 erfasst wurde, können an unterschiedlichen Wicklungen des Dreiwicklungstransformators 60 erfasst werden.

Beispielsweise kann die Prüfantwort, die durch wenigstens eine Messeinrichtung 14, 16 des Transformatorprüfgeräts 10 erfasst wurde, an einer primären oder sekundären Wicklung des Dreiwicklungstransformators 60 erfasst werden, und die weitere Prüfantwort, die durch wenigstens eine Messeinrichtung 47, 49 des Erweiterungsgeräts 40 erfasst wurde, kann an einer tertiären Wicklung des Dreiwicklungstransformators 60 erfasst werden. Die Prüfantwort, die durch wenigstens eine Messeinrichtung 14, 16 des Transformatorprüfgeräts 10 erfasst wurde, kann an einer primären oder tertiären Wicklung des Dreiwicklungstransformators 60 erfasst werden, und die weitere Prüfantwort, die durch wenigstens eine Messeinrichtung 47, 49 des Erweiterungsgeräts 40 erfasst wurde, kann an einer sekundären Wicklung des Dreiwicklungstransformators 60 erfasst werden. Die Prüfantwort, die durch wenigstens eine Messeinrichtung 14, 16 des Transformatorprüfgeräts 10 erfasst wurde, kann an einer sekundären oder tertiären Wicklung des Dreiwicklungstransformators 60 erfasst werden, und die weitere Prüfantwort, die durch wenigstens eine Messeinrichtung 47, 49 des Erweiterungsgeräts 40 erfasst wurde, kann an einer sekundären Wicklung des Dreiwicklungstransformators 60 erfasst werden.

Das Transformatorprüfgerät 10 kann die Durchführung der Prüfung des Transformators und die weitere Verarbeitung der erfassten Prüfantworten so kontrollieren, dass eine oder mehrere Kenngrößen des Dreiwicklungstransformators 60 ermittelt werden. Beispielsweise können von der Auswerteeinrichtung 18 mehrere Übersetzungsverhältnisse des Transformators automatisch bestimmt werden, ohne hierfür eine Umverdrahtung vornehmen zu müssen. Es können auch andere Kenngrößen wie statische oder dynamische Widerstände oder eine Streureaktanz und/oder eine Streuinduktivität des Transformators ermittelt werden. Dazu kann von der Auswerteeinrichtung 18 eine Prüfantwort ausgewertet werden, die als Reaktion auf ein Prüfsignal unter Verwendung von Messeinrichtungen des Transformatorprüfgeräts 10 und des Erweiterungsgeräts 40 erfasst wird.

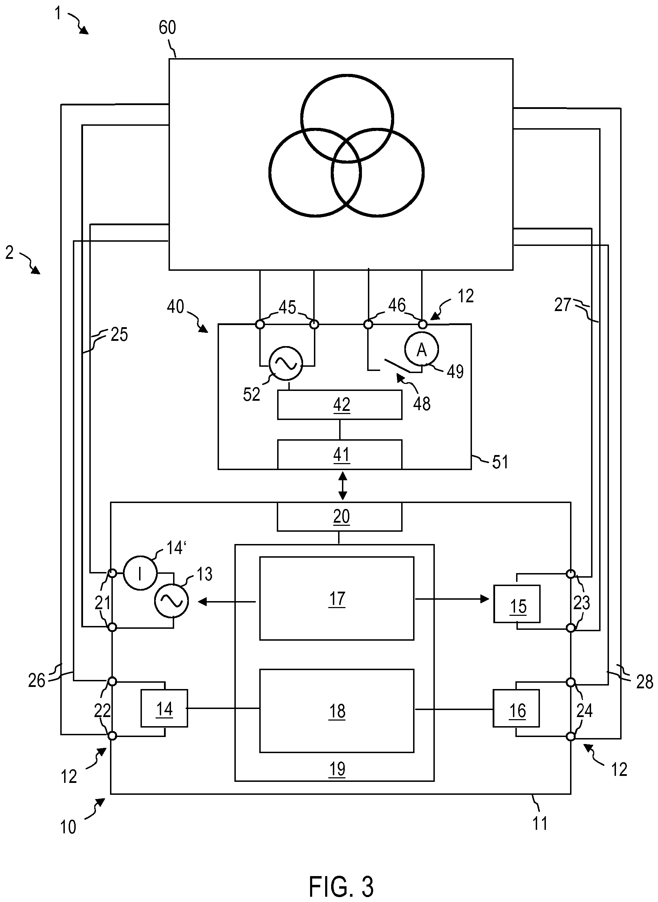

Figur 3 ist eine Darstellung eines Systems 1 mit einer Transformatorprüfvorrichtung 2 und einem Dreiwicklungstransformator 60. Komponenten und Einrichtungen, die mit denselben Bezugszeichen wie in Figur 1 versehen sind, können wie unter Bezugnahme auf Figur 1 beschrieben ausgestaltet sein.

Die Transformatorprüfvorrichtung 2 umfasst ein Transformatorprüfgerät 10 und ein davon verschiedenes Erweiterungsgerät 40. Das Erweiterungsgerät 40 kann ein separates Gehäuse 51 aufweisen und kann über eine digitale Schnittstelle 41 mit dem Transformatorprüfgerät 10 verbunden sein.

Das Erweiterungsgerät 40 weist mehrere Anschlüsse 45, 46 zur Verbindung mit wenigstens einer Wicklung des Dreiwicklungstransformators 60 auf. Das Erweiterungsgerät 40 kann beispielsweise eingerichtet sein, um über die mehreren Anschlüsse 45, 46 mit einer tertiären Wicklung eines Dreiwicklungstransformators 60 gekoppelt zu werden. Das Erweiterungsgerät 40 kann eingerichtet sein, um über die Anschlüsse 45, 46 mit wenigstens einer Wicklung des Dreiwicklungstransformators 60 leitend verbunden zu werden, mit der das Transformatorprüfgerät 10 selbst nicht leitend verbunden ist.

Das Erweiterungsgerät 40 weist eine Quelle 52 auf. Die Quelle 52 kann eingerichtet sein, um ein Signal als Prüfsignal in wenigstens eine Wicklung des Dreiwicklungstransformators 60 einzuprägen. Die Quelle 52 kann von dem Transformatorprüfgerät 10 angesteuert werden. Die Ansteuerung kann unmittelbar derart erfolgen, dass die Quelle 52 mit der Schnittstelle 41 gekoppelt ist und das Transformatorprüfgerät 10 die Quelle 52 in Echtzeit steuert. Die Ansteuerung kann eine Umsetzung von an der Schnittstelle 41 empfangenen Daten durch die Steuereinrichtung 42 des Erweiterungsgeräts 40 umfassen.

Die Quelle 52 kann eine Stromquelle sein, die steuerbar ist, um einen Wechselstrom als Prüfsignal zu erzeugen. Die Quelle 52 kann steuerbar sein, um Wechselströme mit mehreren unterschiedlichen Frequenzen als Prüfsignal zu erzeugen. Die Quelle 52 kann auch eine Spannungsquelle sein. Die Quelle 52 kann in unterschiedlichen Betriebsmodi betreibbar sein, beispielsweise als Stromquelle oder als Spannungsquelle und/oder als Quelle eines zeitlich konstanten Signals oder eines Wechselsignals. Das von der Quelle 52 erzeugte Prüfsignal kann über die Anschlüsse 45 und die Leitungen zwischen den Anschlüssen 45 und dem Dreiwicklungstransformator 60 an wenigstens einer Wicklung an der Unterspannungsseite 43 eingeprägt werden.

Die Quelle 13 des Transformatorprüfgeräts 10 und die Quelle 52 des Erweiterungsgeräts 40 können zeitlich miteinander koordiniert unter der Kontrolle der Steuereinrichtung 18 gesteuert werden. Die Quelle 13 des Transformatorprüfgeräts 10 und die Quelle 52 des Erweiterungsgeräts 40 können so gesteuert werden, dass sequentiell von unterschiedlichen Quellen in unterschiedliche Wicklungen das Prüfsignal eingespeist und jeweils die Prüfantwort erfasst wird.

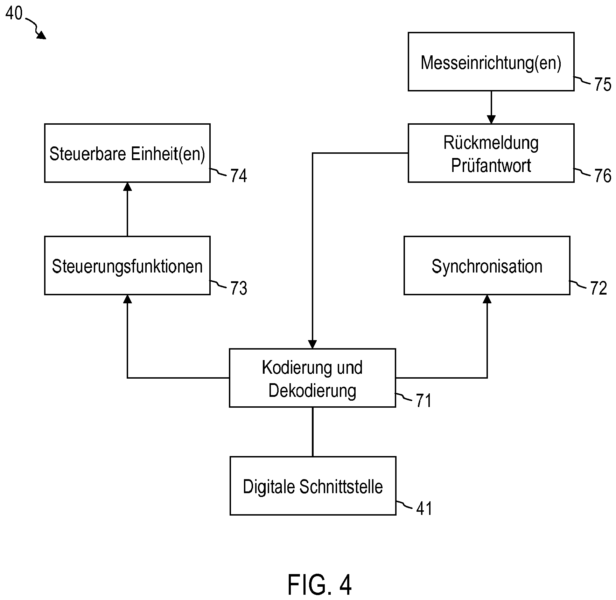

Figur 4 ist ein Funktions-Blockdiagramm eines Erweiterungsgeräts 40 nach einem Ausführungsbeispiel. Mehrere der dargestellten Funktionsblöcke können durch dieselbe physische Einheit implementiert werden.

Das Erweiterungsgerät 40 ist für eine Verbindung mit einem Transformatorprüfgerät 10 ausgestaltet. Das Erweiterungsgerät 40 weist eine Schnittstelle 41 auf, die als digitale Schnittstelle ausgestaltet sein kann. Die Schnittstelle 41 des Erweiterungsgeräts 40 kann eine Ethernet-Schnittstelle sein. Die Schnittstelle 41 des Erweiterungsgeräts 40 kann eine Echtzeit-Ethernet-Schnittstelle sein. Die Schnittstelle 41 des Erweiterungsgeräts 40 kann eine EtherCAT-Schnittstelle sein.

Das Erweiterungsgerät 40 kann ein Modul 71 zur Umsetzung von an der Schnittstelle 41 empfangenen Signalen aufweisen. Das Modul 71 kann empfangene Signale verarbeiten, um von dem Transformatorprüfgerät 10 empfangene Daten aus den empfangenen Signalen zu dekodieren. Das Modul 71 kann Information über eine Prüfantwort oder andere Information, die von dem Erweiterungsgerät 40 zu dem Transformatorprüfgerät 10 übertragen werden soll, in Signale umsetzen, die über die Schnittstelle 41 ausgegeben werden.

Das Erweiterungsgerät 40 kann ein Modul 72 zur Synchronisation mit dem Transformatorprüfgerät 10 umfassen. Das Modul 72 zur Synchronisation kann eine Synchronisation derart erzeugen, dass Messvorgänge und/oder Schaltvorgänge und/oder die Erzeugung eines Prüfsignals von dem Erweiterungsgerät 40 synchronisiert mit einem Prüfablauf, der von dem Transformatorprüfgerät 10 definiert wird, ausgeführt wird. Das Modul 72 zur Synchronisation kann auch weggelassen werden, beispielsweise wenn eine Ansteuerung des Erweiterungsgeräts 40 über eine Echtzeitschnittstelle erfolgt.

Das Erweiterungsgerät 40 kann ein Modul 73 zur Ausführung von Steuerfunktionen umfassen. Das Modul 73 zur Ausführung von Steuerfunktionen kann wenigstens ein steuerbares Schaltmittel des Erweiterungsgeräts 40 als Antwort auf an der Schnittstelle 41 empfangene Daten steuern. Die Ansteuerung kann als Echtzeit-Ansteuerung oder mit einem zeitlichen Versatz zum Datenempfang erfolgen. Das Modul 73 zur Ausführung von Steuerfunktionen kann das wenigstens eine steuerbare Schaltmittel zum Kurzschließen wenigstens einer Wicklung des Dreiwicklungstransformators 40 ansteuern.

Alternativ oder zusätzlich kann das Modul 73 zur Ausführung von Steuerfunktionen eingerichtet sein, um eine Quelle 52 des Erweiterungsgeräts 40 anzusteuern. Das Modul 73 zur Ausführung von Steuerfunktionen kann die Quelle 52 als Antwort auf an der Schnittstelle 41 empfangene Daten steuern. Die Ansteuerung kann als Echtzeit-Ansteuerung oder mit einem zeitlichen Versatz zum Datenempfang erfolgen.

Das Erweiterungsgerät 40 kann eine oder mehrere Einheiten 74 umfassen, die steuerbar sind. Die steuerbare Einheit 74 oder die steuerbaren Einheiten 74 kann bzw. können ein steuerbares Schaltmittel 47, eine Quelle 52 oder andere Einheiten aufweisen.

Das Erweiterungsgerät 40 kann eine oder mehrere Messeinrichtungen 75 zum Erfassen einer Prüfantwort umfassen. Die Messeinrichtung(en) 75 kann bzw. können ein Voltmeter, ein Amperemeter, ein Wattmeter oder andere Messeinrichtungen aufweisen.

Das Erweiterungsgerät 40 kann ein Modul 76 zum Rückmelden einer Prüfantwort an das Transformatorprüfgerät 10 umfassen. Das Modul 76 zum Rückmelden einer Prüfantwort kann Ausgangssignale der Messeinrichtung(en) 75 weiter verarbeiten. Beispielsweise kann das Modul 76 eine Phasenlage einer Prüfantwort relativ zu einem Prüfsignal bestimmen, um die Phasenlage an das Transformatorprüfgerät 10 rückzumelden.

Die Funktionen mehrerer Module können in einem physischen Element kombiniert sein. Beispielsweise kann eine integrierte Halbleiterschaltung die Funktionen des Moduls 73 zur Ansteuerung, des Moduls 71 zur Kodierung und Dekodierung von Signalen und des Module 76 zur Rückmeldung einer Prüfantwort ausführen.

Die Transformatorprüfvorrichtung 2 nach Ausführungsbeispielen kann für Dreiwicklungstransformatoren unterschiedlicher Vektorgruppen und unterschiedlicher Schaltgruppen eingesetzt werden.

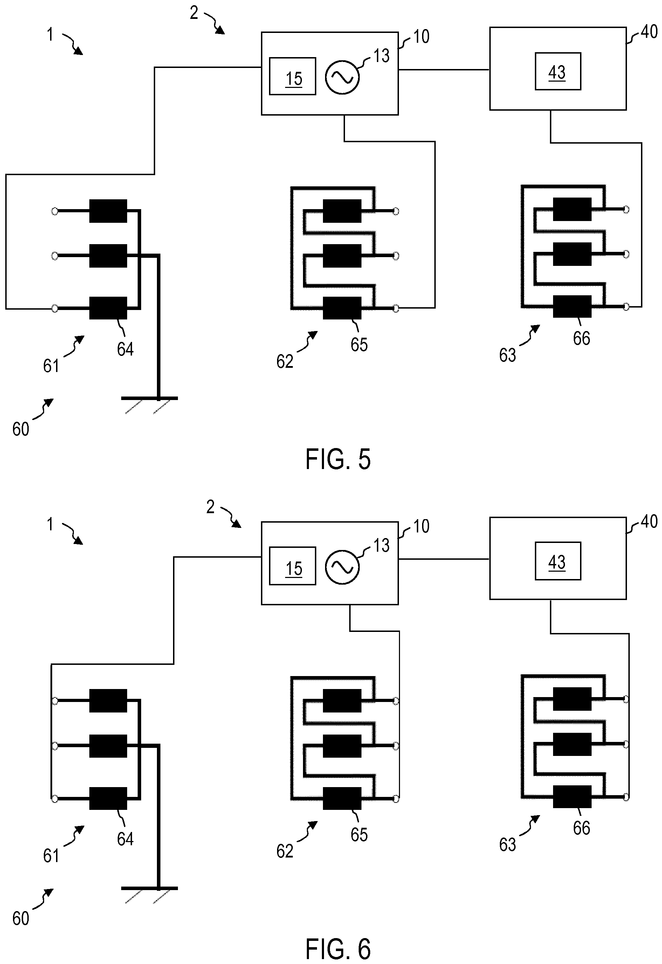

Figur 5 zeigt ein System 1 mit einer Transformatorprüfvorrichtung 2 nach einem Ausführungsbeispiel. Die Transformatorprüfvorrichtung 2 ist mit einem Yndd-Dreiwicklungstransformator 60 gekoppelt. Der Dreiwicklungstransformator 60 weist bei dem beispielhaft dargestellten System 1 drei primäre Wicklungen 61 auf, die in einer Sternkonfiguration mit geerdetem Sternpunkt verschaltet sind. Der Dreiwicklungstransformator 60 weist bei dem beispielhaft dargestellten System 1 drei sekundäre Wicklungen 62 in einer Delta-Verschaltung auf. Der Dreiwicklungstransformator 60 weist bei dem beispielhaft dargestellten System 1 drei tertiäre Wicklungen 63 in einer Delta-Verschaltung auf.

Das Transformatorprüfgerät 10 kann mit wenigstens einer primären Wicklung 64 und mit wenigstens einer sekundären Wicklung 65 leitend verbunden sein. Das Erweiterungsgerät 40 kann mit wenigstens einer tertiären Wicklung 66 leitend verbunden sein, mit der das Transformatorprüfgerät 10 selbst nicht leitend verbunden ist.

Alternativ kann die Transformatorprüfvorrichtung 2 auch so eingesetzt werden, dass das Transformatorprüfgerät 10 mit wenigstens einer sekundären Wicklung und mit wenigstens einer tertiären Wicklung leitend verbunden ist und das Erweiterungsgerät 40 mit wenigstens einer primären Wicklung leitend verbunden sein, mit der das Transformatorprüfgerät 10 selbst nicht leitend verbunden ist.

Alternativ kann die Transformatorprüfvorrichtung 2 auch so eingesetzt werden, dass das Transformatorprüfgerät 10 mit wenigstens einer primären Wicklung und mit wenigstens einer tertiären Wicklung leitend verbunden ist und das Erweiterungsgerät 40 mit wenigstens einer sekundären Wicklung leitend verbunden sein, mit der das Transformatorprüfgerät 10 selbst nicht leitend verbunden ist.

Die Funktionsweise und Ausgestaltung der Transformatorprüfvorrichtung 2 kann wie unter Bezugnahme auf Figur 1 bis Figur 4 beschrieben implementiert sein.

Figur 6 zeigt ein System 1 mit einer Transformatorprüfvorrichtung 2 nach einem Ausführungsbeispiel. Die Transformatorprüfvorrichtung 2 ist mit einem Yndd-Dreiwicklungstransformator 60 gekoppelt.

Die Transformatorprüfvorrichtung 2 kann mit mehreren primären Wicklungen, mit mehreren sekundären Wicklungen und/oder mit mehreren tertiären Wicklungen leitend verbunden sein.

Das Transformatorprüfgerät 10 kann mit den primären Wicklungen 61 und mit den sekundären Wicklungen 62 leitend verbunden sein. Das Erweiterungsgerät 40 kann mit den tertiären Wicklungen 63 leitend verbunden sein, mit denen das Transformatorprüfgerät 10 selbst nicht leitend verbunden ist.

Alternativ kann die Transformatorprüfvorrichtung 2 auch so eingesetzt werden, dass das Transformatorprüfgerät 10 mit den sekundären Wicklungen und den tertiären Wicklungen leitend verbunden ist und das Erweiterungsgerät 40 mit den primären Wicklungen leitend verbunden ist, mit denen das Transformatorprüfgerät 10 selbst nicht leitend verbunden ist.

Alternativ kann die Transformatorprüfvorrichtung 2 auch so eingesetzt werden, dass das Transformatorprüfgerät 10 mit den primären Wicklungen und den tertiären Wicklungen leitend verbunden ist und das Erweiterungsgerät 40 mit den sekundären Wicklungen leitend verbunden sein, mit denen das Transformatorprüfgerät 10 selbst nicht leitend verbunden ist.

Die Funktionsweise und Ausgestaltung der Transformatorprüfvorrichtung 2 kann wie unter Bezugnahme auf Figur 1 bis Figur 4 beschrieben implementiert sein. Insbesondere kann die Transformatorprüfvorrichtung 2 selektiv in eine oder mehrere Wicklungen ein Prüfsignal einprägen und die Prüfantwort an einer oder mehreren anderen Wicklungen erfassen.

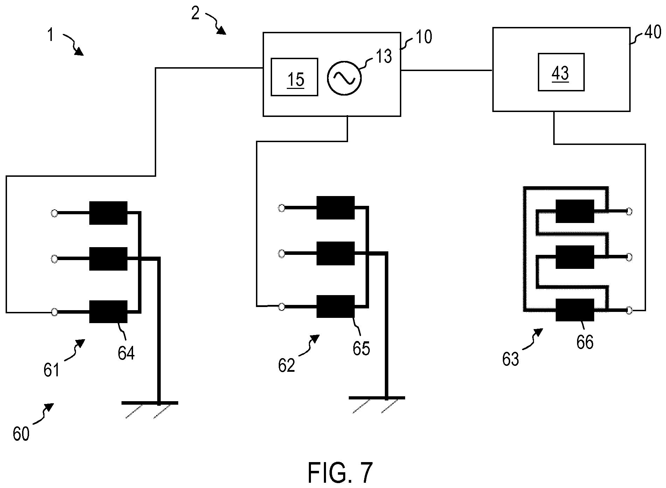

Die Transformatorprüfvorrichtung 2 kann zur Prüfung von Transformatoren unterschiedlicher Schaltgruppen eingesetzt werden. Insbesondere ist die Verwendung nicht auf Yndd-Transformatoren begrenzt, wie in Figur 7 beispielhaft dargestellt ist.

Figur 5 zeigt ein System 1 mit einer Transformatorprüfvorrichtung 2 nach einem Ausführungsbeispiel. Die Transformatorprüfvorrichtung 2 ist mit einem Ynynd-Dreiwicklungstransformator 60 gekoppelt. Der Dreiwicklungstransformator 60 weist bei dem beispielhaft dargestellten System 1 drei primäre Wicklungen 61 auf, die in einer Sternkonfiguration mit geerdetem Sternpunkt verschaltet sind. Der Dreiwicklungstransformator 60 weist bei dem beispielhaft dargestellten System 1 drei sekundäre Wicklungen 62 auf, die in einer Sternkonfiguration mit geerdetem Sternpunkt verschaltet sind. Der Dreiwicklungstransformator 60 weist bei dem beispielhaft dargestellten System 1 drei tertiäre Wicklungen 63 in einer Delta-Verschaltung auf.

Das Transformatorprüfgerät 10 kann mit wenigstens einer primären Wicklung 64 und mit wenigstens einer sekundären Wicklung 65 leitend verbunden sein. Das Erweiterungsgerät 40 kann mit wenigstens einer tertiären Wicklung 66 leitend verbunden sein, mit der das Transformatorprüfgerät 10 selbst nicht leitend verbunden ist.

Alternativ kann die Transformatorprüfvorrichtung 2 auch so eingesetzt werden, dass das Transformatorprüfgerät 10 mit wenigstens einer sekundären Wicklung und mit wenigstens einer tertiären Wicklung leitend verbunden ist und das Erweiterungsgerät 40 mit wenigstens einer primären Wicklung leitend verbunden sein, mit der das Transformatorprüfgerät 10 selbst nicht leitend verbunden ist.

Alternativ kann die Transformatorprüfvorrichtung 2 auch so eingesetzt werden, dass das Transformatorprüfgerät 10 mit wenigstens einer primären Wicklung und mit wenigstens einer tertiären Wicklung leitend verbunden ist und das Erweiterungsgerät 40 mit wenigstens einer sekundären Wicklung leitend verbunden sein, mit der das Transformatorprüfgerät 10 selbst nicht leitend verbunden ist.

Die Funktionsweise und Ausgestaltung der Transformatorprüfvorrichtung 2 kann wie unter Bezugnahme auf Figur 1 bis Figur 4 beschrieben implementiert sein.

Während unter Bezugnahem auf Figur 1 bis Figur 7 beispielhaft Transformatorprüfvorrichtungen 2 dargestellt und beschrieben wurden, bei denen die Transformatorprüfvorrichtung 2 eine Kombination aus Transformatorprüfgerät 10 und Erweiterungsgerät 40 umfasst, kann die Transformatorprüfvorrichtung 2 selbst auch als ein einziges Gerät ausgestaltet sein.

Figur 8 zeigt ein System 1 mit einer Transformatorprüfvorrichtung 2 zum Ermitteln einer Kenngröße eines Dreiwicklungstransformators 60 nach einem Ausführungsbeispiel.

Das System 1 umfasst den Dreiwicklungstransformator 60 und die Transformatorprüfvorrichtung 70. Die Transformatorprüfvorrichtung 70 ist als ein einziges Transformatorprüfgerät 70 mit einem Gehäuse 11 ausgebildet. Das Transformatorprüfgerät 70 kann als mobiles Gerät und insbesondere als portables Gerät ausgebildet sein.

Das Transformatorprüfgerät 70 weist zusätzliche Anschlüsse auf, um eine gleichzeitige Verbindung mit den Wicklungen des Dreiwicklungstransformators 60 zu ermöglichen. Beispielsweise kann das Transformatorprüfgerät 70 Anschlüsse 12 zur Verbindung mit einer primären Wicklung, einer sekundären Wicklung und einer tertiären Wicklung des Dreiwicklungstransformators 60 umfassen, die an dem Gehäuse 11 vorgesehen sind.

Das Transformatorprüfgerät 70 umfasst eine Mehrzahl von Anschlüssen 12 zur Verbindung mit dem Dreiwicklungstransformator 60, eine Quelle 13 für ein Prüfsignal, das an den Dreiwicklungstransformator 60 als Prüfling bei der Transformatorprüfung angelegt oder eingeprägt wird, und eine Auswerteeinrichtung 18. Eine oder mehrere Messeinrichtungen 14, 16, 73 zum Erfassen einer Prüfantwort des Dreiwicklungstransformators 60 können in das Transformatorprüfgerät 70 integriert sein. Ein oder mehrere steuerbare Schaltmittel 15 können in das Transformatorprüfgerät 70 integriert sein. Die Quelle 13, wenigstens eine Messeinrichtung 14, 16 und eine Auswerteeinrichtung 18 können in einem Gehäuse 11 des Transformatorprüfgeräts 70 verbaut sein.

Bei dem Transformatorprüfgerät 70 ist an dem Gehäuse 11 eine Mehrzahl von Anschlüssen 12 vorgesehen. Die Mehrzahl von Anschlüssen kann Anschlüsse zur gleichzeitigen leitenden Verbindung mit wenigstens einer primären Wicklung, wenigstens einer sekundären Wicklung und wenigstens einer tertiären Wicklung des Transformatorprüfgeräts 70 umfassen.

Beispielsweise können Anschlüsse 21 vorgesehen sein, um ein Prüfsignal in wenigstens eine primäre Wicklung einzuspeisen. Eine Prüfantwort kann an der wenigstens einen primären Wicklung über Anschlüsse 22 erfasst werden. Über Anschlüsse 23, 24 kann wenigstens eine sekundäre Wicklung kurzgeschlossen und/oder eine Prüfantwort an der wenigstens einen sekundären Wicklung erfasst werden. Über Anschlüsse 74 kann wenigstens eine tertiäre Wicklung kurzgeschlossen und/oder eine Prüfantwort an der wenigstens einen tertiären Wicklung erfasst werden.

Andere Ausgestaltungen und Verwendungen des Transformatorprüfgeräts 70 sind mögliche. Beispielsweise können Anschlüsse 21 vorgesehen sein, um ein Prüfsignal in wenigstens eine sekundäre Wicklung einzuspeisen. Eine Prüfantwort kann an der wenigstens einen sekundären Wicklung über Anschlüsse 22 erfasst werden. Über Anschlüsse 23, 24 kann wenigstens eine primäre Wicklung kurzgeschlossen und/oder eine Prüfantwort an der wenigstens einen primären Wicklung erfasst werden. Über Anschlüsse 74 kann wenigstens eine tertiäre Wicklung kurzgeschlossen und/oder eine Prüfantwort an der wenigstens einen tertiären Wicklung erfasst werden. Bei weiteren Ausgestaltungen können Anschlüsse 21 vorgesehen sein, um ein Prüfsignal in wenigstens eine tertiäre Wicklung einzuspeisen. Eine Prüfantwort kann an der wenigstens einen tertiären Wicklung über Anschlüsse 22 erfasst werden. Über Anschlüsse 23, 24 kann wenigstens eine primäre Wicklung kurzgeschlossen und/oder eine Prüfantwort an der wenigstens einen primären Wicklung erfasst werden. Über Anschlüsse 74 kann wenigstens eine sekundäre Wicklung kurzgeschlossen und/oder eine Prüfantwort an der wenigstens einen sekundären Wicklung erfasst werden.

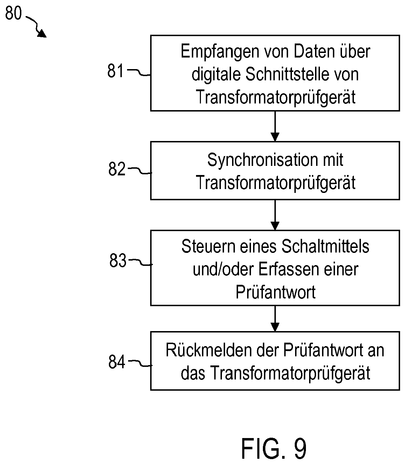

Figur 9 ist ein Flussdiagramm eines Verfahrens 80 nach einem Ausführungsbeispiel. Das Verfahren 80 kann von der Transformatorprüfvorrichtung 2 nach einem Ausführungsbeispiel automatisch ausgeführt werden. Das Verfahren 80 kann von dem Erweiterungsgerät 40 der Transformatorprüfvorrichtung 2 automatisch ausgeführt werden.

Bei Schritt 81 empfängt das Erweiterungsgerät 40 über eine Schnittstelle 41 Daten von einem Transformatorprüfgerät 10. Die Daten können Synchronisationsdaten umfassen, mit denen das Erweiterungsgerät 40 mit dem Transformatorprüfgerät 10 synchronisiert wird. Die Daten können Steuerbefehle für wenigstens ein steuerbares Schaltmittel und/oder für eine Quelle für ein Prüfsignal umfassen.

Bei Schritt 82 kann das Erweiterungsgerät eine Prozedur zur automatischen Synchronisation mit dem Transformatorprüfgerät 10 ausführen.

Bei Schritt 83 kann das Erweiterungsgerät 40 ein steuerbares Schaltmittel, eine steuerbare Quelle für das Prüfsignal und/oder eine andere steuerbar Einheit als Antwort auf die empfangenen Daten steuern. Beispielsweise kann das Erweiterungsgerät 40 ein steuerbares Schaltmittel während wenigstens eines Teils einer Transformatorprüfung so steuern, dass wenigstens eine Wicklung des Dreiwicklungstransformators kurzgeschlossen wird.

Alternativ oder zusätzlich kann das Erweiterungsgerät 40 bei Schritt 83 eine Prüfantwort wenigstens einer Wicklung des Dreiwicklungstransformators erfassen. Die Prüfantwort kann eine Wechselspannung oder ein Wechselstrom sein, der bzw. die zeitabhängig erfasst wird.

Bei Schritt 84 kann das Erweiterungsgerät 40 über die Schnittstelle 41 Daten an das Transformatorprüfgerät 10 ausgeben. Beispielsweise kann die Prüfantwort über die Schnittstelle 41 an das Transformatorprüfgerät 10 gemeldet werden.

Das Verfahren 80 kann weitere Schritte beinhalten. Beispielsweise kann das Verfahren die Auswertung einer Benutzereingabe umfassen, mit der benutzerdefiniert festlegbar ist, welche Kenngrößen des Dreiwicklungstransformators 60 bestimmt werden. Das Verfahren kann die Auswertung einer Benutzereingabe umfassen, mit der benutzerdefiniert festlegbar ist, welche Vektorgruppe oder Schaltgruppe der Dreiwicklungstransformator 60 aufweist.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise bestimmte Messungen wie die Bestimmung von Übersetzungsverhältnissen, von Widerständen, von Streureaktanzen und/oder Streuinduktivitäten beispielhaft beschrieben wurden, können durch die Transformatorprüfvorrichtungen alternativ oder zusätzlich andere Kenngrößen des Dreiwicklungstransformators bestimmt werden.

Während bei Ausführungsbeispielen die Transformatorprüfvorrichtung ein steuerbares Schaltmittel zum Kurzschließen einer Wicklung des Dreiwicklungstransformators umfassen kann, kann die Transformatorprüfvorrichtung auch zwei oder mehr als zwei steuerbare Schaltmittel zum Kurzschließen mehrerer Wicklungen des Dreiwicklungstransformators oder kein derartiges steuerbares Schaltmittel aufweisen. Die Transformatorprüfvorrichtung kann eingerichtet sein, um mehrere Wicklungen gleichzeitig oder zeitsequentiell kurzzuschließen. Das Erweiterungsgerät selbst kann ebenfalls mehr als ein steuerbares Schaltmittel zum Kurzschließen wenigstens einer Wicklung aufweisen.

Während bei Ausführungsbeispielen eine Prozedur, die die Bestimmung mehrerer Kenngrößen des Dreiwicklungstransformators beinhaltet, automatisch ausgeführt werden kann, können die Vorrichtung und das Verfahr nach Ausführungsbeispielen auch verwendet werden, wenn nur eine Kenngröße des Dreiwicklungstransformators, beispielsweise nur das Übersetzungsverhältnis oder nur die Streureaktanz, gemessen wird, bevor eine neue Benutzereingabe erforderlich ist.

Während der Dreiwicklungstransformator in einem Kraftwerk oder Umspannwerk eines Energieversorgungsnetzes installiert sein kann, können die Vorrichtung und das Verfahren nach Ausführungsbeispielen auch bei kleineren Transformatoren eingesetzt werden.

Vorrichtung, Verfahren und Systeme nach Ausführungsbeispielen erlauben eine Ermittlung einer Vielzahl von Kenngrößen eines Dreiwicklungstransformators und ermöglichen eine weitergehende Automatisierung bei der Transformatorprüfung.

## Patentansprüche

1. Transformatorprüfvorrichtung zum Prüfen eines Dreiwicklungstransformators (60), umfassend
eine Quelle (13; 13, 52) zum Erzeugen von Prüfsignalen für den Dreiwicklungstransformator (60),
eine Messeinrichtung (14, 16; 14, 16, 47, 49) zum Erfassen einer Prüfantwort des Dreiwicklungstransformators (60),
Anschlüsse (12) zum lösbaren Verbinden der Transformatorprüfvorrichtung (2; 70) mit dem Dreiwicklungstransformator (60),
ein Transformatorprüfgerät (10), und
ein von dem Transformatorprüfgerät (10) verschiedenes Erweiterungsgerät (40), das mit dem Transformatorprüfgerät (10) verbindbar ist,
wobei die Anschlüsse (12) wenigstens einen Anschluss (44; 45, 46) zum Verbinden mit einer tertiären Wicklung (66) des Dreiwicklungstransformators (60) umfassen, und
wobei das Erweiterungsgerät (40) den wenigstens einen Anschluss (44; 45, 46) zum Verbinden mit der tertiären Wicklung (66) umfasst,
**dadurch gekennzeichnet,**
**dass** das Transformatorprüfgerät (10) durch das Erweiterungsgerät (40) für die Prüfung des Dreiwicklungstransformators (60) umkonfigurierbar ist.

2. Transformatorprüfvorrichtung nach Anspruch 1,
wobei die Anschlüsse (12) wenigstens einen ersten Anschluss zum Verbinden mit einer primären Wicklung (64) des Dreiwicklungstransformators (60) und wenigstens einen zweiten Anschluss zum Verbinden mit einer sekundären Wicklung (65) des Dreiwicklungstransformators (60) umfassen, die von dem wenigstens einen Anschluss zum Verbinden mit der tertiären Wicklung (66) verschieden sind.

3. Transformatorprüfvorrichtung nach Anspruch 1 oder Anspruch 2,
wobei das Erweiterungsgerät (40) eine digitale Schnittstelle (41) umfasst, über die das Erweiterungsgerät (40) mit dem Transformatorprüfgerät (10) verbunden ist, wobei das Erweiterungsgerät (40) für eine Synchronisation mit dem Transformatorprüfgerät (10) über die digitale Schnittstelle (41) eingerichtet ist, und
wobei das Erweiterungsgerät (40) eingerichtet ist, um über die digitale Schnittstelle (41) Information über die Prüfantwort an das Transformatorprüfgerät (10) zu melden.

4. Transformatorprüfvorrichtung nach einem der Ansprüche 1 bis 3,
wobei das Erweiterungsgerät (40) ein steuerbares Schaltmittel (48) zum Kurzschließen wenigstens einer Wicklung des Dreiwicklungstransformators (60) umfasst, und
wobei das Erweiterungsgerät (40) eingerichtet ist, um selektiv wenigstens eine sekundäre Wicklung oder wenigstens eine tertiäre Wicklung des Dreiwicklungstransformators (60) zur Durchführung einer Streureaktanzmessung kurzzuschließen.

5. Erweiterungsgerät für ein Transformatorprüfgerät (10), umfassend eine Schnittstelle (41) zur Kommunikation mit dem Transformatorprüfgerät (10) und
wenigstens einen Anschluss (44; 45, 46) zum lösbaren Verbinden des Erweiterungsgeräts (40) mit einer Wicklung eines Dreiwicklungstransformators (60), wobei der wenigstens eine Anschluss (44; 45, 46) des Erweiterungsgeräts (40) zur Verbindung mit einer tertiären Wicklung (66) des Dreiwicklungstransformators (60) eingerichtet ist,
**dadurch gekennzeichnet,**
**dass** das Erweiterungsgerät (40) eingerichtet ist, um das Transformatorprüfgerät (10) zur Prüfung des Dreiwicklungstransformators (60) umzukonfigurieren.

6. Erweiterungsgerät nach Anspruch 5,
wobei das Erweiterungsgerät (40) oder das Transformatorprüfgerät (10) wenigstens einen zweiten Anschluss (23, 24) zum Verbinden mit einer sekundären Wicklung (65) des Dreiwicklungstransformators (60) umfasst, der von dem wenigstens einen Anschluss (44; 45, 46) zum Verbinden mit der tertiären Wicklung verschieden ist.

7. Erweiterungsgerät nach Anspruch 5 oder Anspruch 6,
wobei die Schnittstelle (41) eine digitale Schnittstelle (41) umfasst,
wobei das Erweiterungsgerät (40) für eine Synchronisation mit dem Transformatorprüfgerät (10) über die digitale Schnittstelle (41) eingerichtet ist, und
wobei das Erweiterungsgerät (40) eingerichtet ist, um über die digitale Schnittstelle (41) Information über eine Prüfantwort des Dreiwicklungstransformators (60) auf ein Prüfsignal an das Prüfgerät zu melden.

8. Erweiterungsgerät nach einem der Ansprüche 5 bis 7, ' wobei das Erweiterungsgerät (40) ein steuerbares Schaltmittel zum Kurzschließen wenigstens einer Wicklung des Dreiwicklungstransformators (60) umfasst, und wobei das Erweiterungsgerät (40) eingerichtet ist, um selektiv wenigstens eine sekundäre Wicklung oder wenigstens eine tertiäre Wicklung des Dreiwicklungstransformators (60) zur Durchführung einer Streureaktanzmessung kurzzuschließen.

9. System, umfassend
einen Dreiwicklungstransformator (60), und
das Erweiterungsgerät (40) nach einem der Ansprüche 5 bis 8,
wobei das Erweiterungsgerät (40) mit wenigstens einer Wicklung des Dreiwicklungstransformators (60) verbunden ist.

10. System nach Anspruch 9,
wobei eine primäre Wicklung, eine sekundäre Wicklung und eine tertiäre Wicklung des Dreiwicklungstransformators (60) mit demselben Transformatorkern gekoppelt sind.

11. System nach Anspruch 9,
wobei der Dreiwicklungstransformator (60) ein Dreiphasen-Dreiwicklungstransformator ist.

12. System nach einem der Ansprüche 9 bis 11, umfassend
ein von dem Erweiterungsgerät (40) verschiedenes Transformatorprüfgerät (10), das mit dem Erweiterungsgerät (40) verbunden ist.

13. System nach Anspruch 12,
wobei sowohl das Transformatorprüfgerät (10) als auch das Erweiterungsgerät (40) direkt mit dem Dreiwicklungstransformator (60) verbunden ist.

14. Verfahren zum Prüfen eines Dreiwicklungstransformators (60) mit einer Transformatorprüfvorrichtung (2; 70), die Anschlüsse (12) zum lösbaren Verbinden der Transformatorprüfvorrichtung mit dem Dreiwicklungstransformator (60), ein Transformatorprüfgerät (10) und ein von dem Transformatorprüfgerät (10) verschiedenes Erweiterungsgerät (40), das mit dem Transformatorprüfgerät (10) verbindbar ist, umfasst, wobei das Verfahren umfasst:
Erzeugen eines Prüfsignals für den Dreiwicklungstransformator (60) und
Erfassen einer Prüfantwort des Dreiwicklungstransformators (60),
wobei die Anschlüsse (12) wenigstens einen Anschluss zum Verbinden der Transformatorprüfvorrichtung mit einer tertiären Wicklung (66) des Dreiwicklungstransformators (60) umfassen, und
wobei das Erweiterungsgerät (40) den wenigstens einen Anschluss (44; 45, 46) zum Verbinden mit der tertiären Wicklung (66) umfasst,
**dadurch gekennzeichnet,**
**dass** das Transformatorprüfgerät (10) durch das Erweiterungsgerät (40) für die Prüfung des Dreiwicklungstransformators (60) umkonfiguriert wird.

15. Verfahren nach Anspruch 14,
wobei das Verfahren mit der Transformatorprüfvorrichtung (2; 70) nach einem der Ansprüche 1 bis 4 ausgeführt wird, und
wobei die Transformatorprüfvorrichtung (2) ein Erweiterungsgerät (40) nach einem der Ansprüche 5 bis 8 umfasst.

## Claims

1. A transformer test apparatus for testing a three-winding transformer (60), comprising
a source (13; 13, 52) for generating test signals for the three-winding transformer (60),
a measuring device (14, 16; 14, 16, 47, 49) for detecting a test response of the three-winding transformer (60),
terminals (12) for detachably connecting the transformer test apparatus (2; 70) to the three-winding transformer (60),
a transformer testing device (10), and
an expansion device (40) different from the transformer testing device (10) and connectable to the transformer testing device (10),
wherein the terminals (12) comprise at least one terminal (44; 45, 46) for connection to a tertiary winding (66) of the three-winding transformer (60), and
wherein the expansion device (40) comprises the at least one terminal (44; 45, 46) for connection to the tertiary winding (66),
**characterized in that**
the transformer testing device (10) is reconfigurable by the expansion device (40) for the test of the three-winding transformer (60).

2. The transformer test apparatus according to claim 1,
wherein the terminals (12) comprise at least one first terminal for connection to a primary winding (64) of the three-winding transformer (60) and at least one second terminal for connection to a secondary winding (65) of the three-winding transformer (60) different from the at least one terminal for connection to the tertiary winding (66).

3. The transformer test apparatus according to claim 1 or claim 2,
wherein the expansion device (40) comprises a digital interface (41) via which the expansion device (40) is connected to the transformer testing device (10), wherein the expansion device (40) is configured for synchronization with the transformer testing device (10) via the digital interface (41), and
wherein the expansion device (40) is configured to report information about the test response to the transformer testing device (10) via the digital interface (41).

4. The transformer test apparatus according to any one of claims 1 to 3,
wherein the expansion device (40) comprises a controllable switching means (48) for short-circuiting at least one winding of the three-winding transformer (60), and wherein the expansion device (40) is configured to selectively short-circuit at least one secondary winding or at least one tertiary winding of the three-winding transformer (60) for performing a leakage reactance measurement.

5. An expansion device for a transformer testing device (10), comprising an interface (41) for communication with the transformer testing device (10), and at least one terminal (44; 45, 46) for detachably connecting the expansion device (40) to a winding of a three-winding transformer (60),
wherein the at least one terminal (44; 45, 46) of the expansion device (40) is configured for connection to a tertiary winding (66) of the three-winding transformer (60),
**characterized in that**
the expansion device (40) is configured to reconfigure the transformer testing device (10) for testing the three-winding transformer (60).

6. The expansion device according to claim 5,
wherein the expansion device (40) or the transformer testing device (10) comprises at least one second terminal (23, 24) for connecting to a secondary winding (65) of the three-winding transformer (60), which is different from the at least one terminal (44; 45, 46) for connection to the tertiary winding.

7. The expansion device according to claim 5 or claim 6,
wherein the interface (41) comprises a digital interface (41),
wherein the expansion device (40) is adapted for synchronization with the transformer tester (10) via the digital interface (41), and
wherein the expansion device (40) is configured to report information about a test response of the three-winding transformer (60) to a test signal to the testing device via the digital interface (41).

8. The expansion device according to any one of claims 5 to 7,
wherein the expansion device (40) comprises a controllable switching means for short-circuiting at least one winding of the three-winding transformer (60), and wherein the expansion device (40) is arranged to selectively short-circuit at least one secondary winding or at least one tertiary winding of the three-winding transformer (60) for performing a leakage reactance measurement.

9. A system comprising
a three-winding transformer (60), and
the expansion device (40) according to any one of claims 5 to 8,
wherein the expansion device (40) is connected to at least one winding of the three-winding transformer (60).

10. The system according to claim 9,
wherein a primary winding, a secondary winding, and a tertiary winding of the three-winding transformer (60) are coupled to the same transformer core.

11. The system of claim 9,
wherein the three-winding transformer (60) is a three-phase three-winding transformer.

12. The a system according to any one of claims 9 to 11, comprising a transformer testing device (10) different from the extension device (40), which is connected to the expansion device (40).

13. The system according to claim 12,
wherein both the transformer testing device (10) and the expansion device (40) are directly connected to the three-winding transformer (60).

14. A method for testing a three-winding transformer (60) with a transformer test apparatus (2; 70) comprising terminals (12) for detachably connecting the transformer test apparatus to the three-winding transformer (60), a transformer testing device (10), and an expansion device (40) different from the transformer testing device (10) and connectable to the transformer testing device (10), the method comprising:
generating a test signal for the three-winding transformer (60); and
detecting a test response of the three-winding transformer (60),
wherein the terminals (12) comprise at least one terminal for connecting the transformer test apparatus to a tertiary winding (66) of the three-winding transformer (60), and
wherein the expansion device (40) comprises the at least one terminal (44; 45, 46) for connection to the tertiary winding (66),
**characterized in that**
the transformer testing device (10) is reconfigured by the expansion device (40) for the test of the three-winding transformer (60).

15. The method according to claim 14,
wherein the method is carried out with the transformer test apparatus (2; 70) according to any one of claims 1 to 4, and
wherein the transformer test apparatus (2) comprises an expansion device (40) according to any one of claims 5 to 8.

## Revendications

1. Dispositif de test de transformateur destiné à tester un transformateur à trois enroulements (60), comprenant
une source (13 ; 13, 52) destinée à générer des signaux de test pour le transformateur à trois enroulements (60),
un équipement de mesure (14, 16 ; 14, 16, 47, 49) destiné à détecter une réponse de test du transformateur à trois enroulements (60),
des connexions (12) destinées à raccorder de manière amovible le dispositif de test de transformateur (2 ; 70) au transformateur à trois enroulements (60),
un appareil de test de transformateur (10), et
un appareil d'extension (40) différent de l'appareil de test de transformateur (10) et qui peut être raccordé à l'appareil de test de transformateur (10),
les connexions (12) comprenant au moins une connexion (44 ; 45, 46) destinée au raccordement à un enroulement tertiaire (66) du transformateur à trois enroulements (60), et
l'appareil d'extension (40) comprenant l'au moins une connexion (44 ; 45, 46) destinée au raccordement à l'enroulement tertiaire (66),
**caractérisé en ce**
**que** l'appareil de test de transformateur (10) peut être reconfiguré par l'appareil d'extension (40) pour tester le transformateur à trois enroulements (60).

2. Dispositif de test de transformateur selon la revendication 1,
dans lequel les connexions (12) comprennent au moins une première connexion destinée au raccordement à un enroulement primaire (64) du transformateur à trois enroulements (60) et au moins une seconde connexion destinée au raccordement à un enroulement secondaire (65) du transformateur à trois enroulements (60), lesquelles connexions sont différentes de l'au moins une connexion destinée au raccordement à l'enroulement tertiaire (66).

3. Dispositif de test de transformateur selon la revendication 1 ou la revendication 2,
dans lequel l'appareil d'extension (40) comprend une interface numérique (41) par l'intermédiaire de laquelle l'appareil d'extension (40) est raccordé à l'appareil de test de transformateur (10), dans lequel l'appareil d'extension (40) est configuré pour une synchronisation avec l'appareil de test de transformateur (10) par l'intermédiaire de l'interface numérique (41), et
dans lequel l'appareil d'extension (40) est configuré pour rapporter des informations concernant la réponse de test à l'appareil de test de transformateur (10) par l'intermédiaire de l'interface numérique (41).

4. Dispositif de test de transformateur selon l'une des revendications 1 à 3,
dans lequel l'appareil d'extension (40) comprend un moyen de commutation commandable (48) destiné à court-circuiter au moins un enroulement du transformateur à trois enroulements (60), et
dans lequel l'appareil d'extension (40) est configuré pour court-circuiter sélectivement au moins un enroulement secondaire ou au moins un enroulement tertiaire du transformateur à trois enroulements (60) afin d'effectuer une mesure de réactance de fuite.

5. Appareil d'extension pour un appareil de test de transformateur (10), comprenant
une interface (41) destinée à la communication avec l'appareil de test de transformateur (10) et
au moins une connexion (44 ; 45, 46) destinée à raccorder de manière amovible l'appareil d'extension (40) à un enroulement d'un transformateur à trois enroulements (60), l'au moins une connexion (44 ; 45, 46) de l'appareil d'extension (40) étant configurée pour un raccordement à un enroulement tertiaire (66) du transformateur à trois enroulements (60),
**caractérisé en ce**
**que** l'appareil d'extension (40) est configuré pour reconfigurer l'appareil de test de transformateur (10) afin de tester le transformateur à trois enroulements (60).

6. Appareil d'extension selon la revendication 5,
dans lequel l'appareil d'extension (40) ou l'appareil de test de transformateur (10) comprend au moins une seconde connexion (23, 24) destinée au raccordement à un enroulement secondaire (65) du transformateur à trois enroulements (60) et qui est différente de l'au moins une connexion (44 ; 45, 46) destinée au raccordement à l'enroulement tertiaire.

7. Appareil d'extension selon la revendication 5 ou la revendication 6,
dans lequel l'interface (41) comprend une interface numérique (41),
dans lequel l'appareil d'extension (40) est configuré pour une synchronisation avec l'appareil de test de transformateur (10) par l'intermédiaire de l'interface numérique (41), et
dans lequel l'appareil d'extension (40) est configuré pour rapporter des informations concernant une réponse de test du transformateur à trois enroulements (60) en tant que signal de test à l'appareil de test par l'intermédiaire de l'interface numérique (41).

8. Appareil d'extension selon l'une des revendications 5 à 7,
dans lequel l'appareil d'extension (40) comprend un moyen de commutation commandable destiné à court-circuiter au moins un enroulement du transformateur à trois enroulements (60), et dans lequel l'appareil d'extension (40) est configuré pour court-circuiter sélectivement au moins un enroulement secondaire ou au moins un enroulement tertiaire du transformateur à trois enroulements (60) afin d'effectuer une mesure de réactance de fuite.

9. Système, comprenant
un transformateur à trois enroulements (60), et
l'appareil d'extension (40) selon l'une des revendications 5 à 8, l'appareil d'extension (40) étant raccordé à au moins un enroulement du transformateur à trois enroulements (60).

10. Système selon la revendication 9,
dans lequel un enroulement primaire, un enroulement secondaire et un enroulement tertiaire du transformateur à trois enroulements (60) sont couplés au même noyau de transformateur.

11. Système selon la revendication 9,
dans lequel le transformateur à trois enroulements (60) est un transformateur triphasé à trois enroulements.

12. Système selon l'une des revendications 9 à 11, comprenant
un appareil de test de transformateur (10) différent de l'appareil d'extension (40) et raccordé à l'appareil d'extension (40).

13. Système selon la revendication 12,
dans lequel l'appareil de test de transformateur (10) ainsi que l'appareil d'extension (40) sont directement raccordés au transformateur à trois enroulements (60).

14. Procédé destiné à tester un transformateur à trois enroulements (60) comportant un dispositif de test de transformateur (2 ; 70), les connexions (12) destinées à raccorder de manière amovible le dispositif de test de transformateur au transformateur à trois enroulements (60), un appareil de test de transformateur (10) et un appareil d'extension (40) différent de l'appareil de test de transformateur (10) et pouvant être raccordé à l'appareil de test de transformateur (10), le procédé comprenant :
la génération d'un signal de test pour le transformateur à trois enroulements (60) et
la détection d'une réponse de test du transformateur à trois enroulements (60),
dans lequel les connexions (12) comprennent au moins une connexion destinée à raccorder le dispositif de test de transformateur à un enroulement tertiaire (66) du transformateur à trois enroulements (60), et
l'appareil d'extension (40) comprenant l'au moins une connexion (44 ; 45, 46) destinée au raccordement à l'enroulement tertiaire (66),
**caractérisé en ce**
**que** l'appareil de test de transformateur (10) est reconfiguré par l'appareil d'extension (40) pour tester le transformateur à trois enroulements (60).

15. Procédé selon la revendication 14,
dans lequel le procédé est exécuté avec le dispositif de test de transformateur (2 ; 70) selon l'une des revendications 1 à 4, et
dans lequel le dispositif de test de transformateur (2) comprend un appareil d'extension (40) selon l'une des revendications 5 à 8.
